# EUROPEAN PATENT APPLICATION

(11) **EP 1 017 168 A2**
(43) Date of publication of application: **05.07.2000**
(21) Application number: 99125996.1
(22) Date of filing: 28.12.1999
(51) Int. Cl.: H03H 9/05

(54) **Surface acoustic wave device and package for surface acoustic wave element**

(30) Priority: 28.12.1998 JP 37381998; 23.02.1999 JP 4546599
(71) Applicant: KABUSHIKI KAISHA TOSHIBA, Kawasaki-shi, Kanagawa-ken 210-8572 (JP)
(72) Inventor: Kawaguchi, Kyoko, 1-1-1 Shibaura, Minato-ku, Tokyo 105 (JP)
(74) Representative: HOFFMANN - EITLE

(57) **Abstract**

A surface acoustic wave element comprising a surface acoustic wave absorbing member is mounted on a support base by use of FDB method to obtain a surface acoustic wave device of smaller size and excellent frequency characteristics. In a surface acoustic wave device of the present invention, in an area facing a surface acoustic wave absorbing member on a die-attach surface of a support base, a concave is disposed. On such a die-attach surface of a support base, a surface acoustic wave element is disposed face-down to mount, and a surface acoustic wave absorbing member is embedded, in the absence of contact, in a concave 9 of a support base 2. A bonding pad of a surface acoustic wave element and a signal terminal of a support base are connected through Au bump.

## Description

The present invention relates to a surface acoustic wave device and a package, in particular, relates to a surface acoustic wave device of small size and excellent frequency characteristics, and a package for such a surface acoustic wave element.

In a surface acoustic wave element, a pair of comb-electrodes (IDT: Inter Digital Transducer) consisting of thin metallic film disposed on a substrate consisting of piezoelectric material (piezoelectric substrate) such as LiTaO₃, LiNbO₃ and quartz carry out conversion between electrical signals and surface acoustic waves (SAW) to transmit and receive signal. A surface acoustic wave device, being small, light, highly reliable and excellent in out of band attenuation characteristics, in the field of imaging devices and mobile communication units, is used in large as a frequency filter, a resonator or the like.

Recently, in a surface acoustic wave device having such a surface acoustic wave element, in order to attain smaller size, a surface acoustic wave element is mounted and assembled on a support base by use of connection method called face-down bonding method (hereinafter refers to as FDB method).

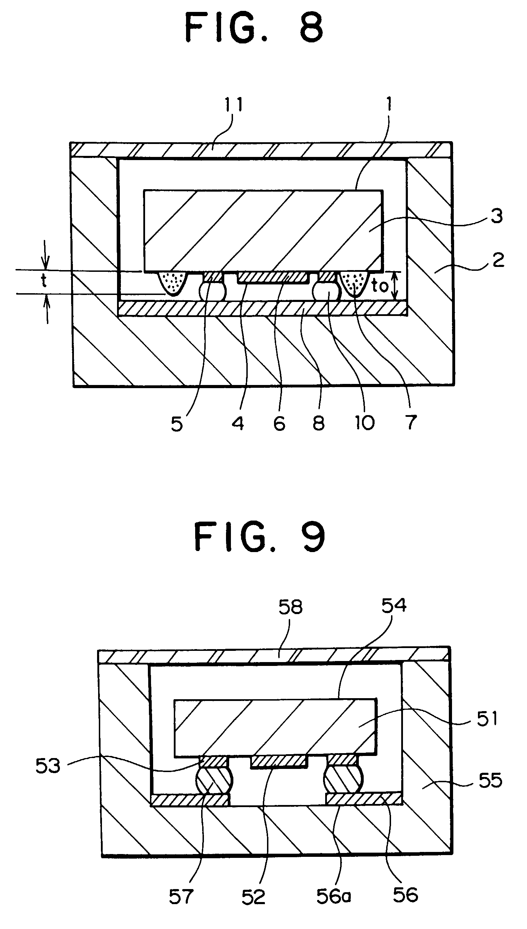

Fig. 9 shows a surface acoustic wave device connected by the existing FDB method. In the figure, a surface acoustic wave element 54 in which a comb-electrode 52 and bonding pads 53 are formed on a piezoelectric substrate 51, respectively, is mounted in a box of, for instance, ceramic support base 55 in face-down way with an electrode surface facing downward. On a connection surface (die-attach surface) facing a surface acoustic wave element 54 of the support base 55, a conductor pattern 56 is formed. A signal terminal 56a of the conductor pattern 56 is connected (flip chip mounting) with a bonding pad 53 of the surface acoustic wave element 54 through a conductive bump 57 such as Au, solder or the like. In addition, at an upper edge portion of the support base 55, a cap 58 made of metal or ceramics is disposed to cover, the cap 58 and the support base 55 being welded or adhered with an adherent to seal. On the conductor pattern 56 on the die-attach surface of the support base 55, so as to secure conductivity of the signal terminal 56a, a layer of plating of such as Au or the like is formed with a thickness of 1 to 10 µm (not shown in the figure). Further, on the exterior surface of the support base 55, external connection terminals (not shown in the figure) are disposed, the external connection terminals and the aforementioned signal terminals 56a being held conductive through conductive paths (not shown in the figure) such as via-holes or the like.

Now, in some cases, a surface acoustic wave element has a surface acoustic wave absorbing member. That is, to suppress an influence of waves leaked from the IDT or the like, on an electrode surface of the piezoelectric substrate, a layer of resin material of silicone type or epoxy type, which are absorbing material of surface acoustic waves, is disposed.

The present invention is carried out to solve the problems when a surface acoustic wave element having a surface acoustic wave absorbing member is bonded by use of the FDB method.

Namely, the following are objects of the present invention.
(1) To reduce detects such as disconnection between a surface acoustic wave element and a support base, in mounting the surface acoustic wave element having a surface acoustic wave absorbing member on the support base by use of the FDB method.
(2) To provide a surface acoustic wave device of smaller size and excellent frequency characteristics.
(3) To provide a package for a surface acoustic wave element appropriate for manufacture of a surface acoustic wave device of smaller size and excellent frequency characteristics.

A surface acoustic wave device involving a first invention of the present invention comprises a surface acoustic wave element having a piezoelectric substrate, and a comb-electrode and a surface acoustic wave absorbing member both of which are formed on the piezoelectric substrate, and a support base thereon the surface acoustic wave element is mounted with face down. Here, the support base comprises a conductor layer formed on a surface facing the surface acoustic wave element and connected with the surface acoustic wave element through a bump. Here, the support base comprises a concave portion in an area facing the surface acoustic wave absorbing member.

A surface acoustic wave device involving a second invention of the present invention comprises a surface acoustic wave element having a piezoelectric substrate, and a comb-electrode and a surface acoustic wave absorbing member both of which are formed on the piezoelectric substrate, and a support base thereon the surface acoustic wave element is mounted in face-down way. Here, the support base comprises a conductor layer formed on a surface facing the surface acoustic wave element and connected with the surface acoustic wave element through a bump. Here, a connection area connecting with the bump on the support base is formed on a portion protruded in a thickness direction compared with the area facing the surface acoustic wave absorbing member.

A surface acoustic wave device involving a third invention of the present invention comprises a surface acoustic wave element having a piezoelectric substrate, and a comb-electrode and a surface acoustic wave absorbing member both of which are formed on the piezoelectric substrate, and a support base thereon the surface acoustic wave element is mounted in face-down way. Here, the support base comprises a conductor layer formed on a surface facing the surface acoustic wave element and connected with the surface acoustic wave element through a bump. Here, a thickness of the surface acoustic wave absorbing member is smaller than a gap between one surface of the surface acoustic wave element thereon the comb-electrode is formed and the conductor layer.

A package used for a surface acoustic wave element comprising a surface acoustic wave absorbing member involving a fourth invention of the present invention comprises a support base having one surface thereon a surface acoustic wave element is mounted, a conductor layer formed on the aforementioned surface, and a concave portion formed in an area facing the surface acoustic wave absorbing member on the aforementioned surface.

A package for a surface acoustic wave element involving a fifth invention comprises a support base having one surface thereon the aforementioned surface acoustic wave element is mounted, a portion disposed in an area where the aforementioned surface acoustic wave element on the surface is connected and protruded in a direction of thickness of the support base, and a conductor layer formed on the protrusion.

In a surface acoustic wave device involving the first invention of the present invention and a package involving the fourth invention, in an area forming a conductor layer thereon and facing a surface acoustic wave absorbing member of the surface acoustic wave element on a surface of the support base, a concave portion is disposed. Accordingly, without the surface acoustic wave absorbing member being contact with the surface of the support base where the conductor layer is formed, a surface acoustic wave element can be mounted and assembled. Accordingly, a surface acoustic wave element having a surface acoustic wave absorbing member, without increasing the bump size, can be mounted and assembled on the support base by use of FDB method, resulting in a surface acoustic wave device of smaller size and excellent frequency characteristics.

Further, the surface acoustic wave absorbing member can be constituted to fit in without contacting a concave portion of the support base. In addition, in such a constitution, into the concave portion where the surface acoustic wave absorbing member is fit in, insulating resin can be filled to connect the resin-filled layer and the surface acoustic wave absorbing member. Thus, the surface acoustic wave element and the support base can be further strengthened in mechanical connection.

In a surface acoustic wave device involving the second invention and a package involving the fifth invention, a bump connection area on a conductor surface of a support base, compared with an area facing a surface acoustic wave absorbing member, is formed protruding in a direction of the thickness of the support base. Accordingly, without the surface acoustic wave absorbing member making a contact with the surface of the support base where the conductor layer is formed, the surface acoustic wave element can be mounted and assembled. Accordingly, a surface acoustic wave element having a surface acoustic wave absorbing member, without increasing the bump size, can be mounted and assembled by use of the FDB method, resulting in a surface acoustic wave device of smaller size and excellent frequency characteristics.

In such a surface acoustic wave device of the present invention and a package for a surface acoustic wave device, a depth of a concave portion disposed on a conductor surface of the support base, or a height of a step of a protruded portion, when exceeding the difference of the thickness of the surface acoustic wave absorbing member and the height of the bump, can be sufficiently effective.

In specific, considering surface roughness of a conductor surface of the support base and scattering of the height of the bumps, it is preferable to set at 2 µm or more. Further, the upper limit of the depth of the concave portion or the height of the step of the protruded portion is not particularly restricted. However, considering the present invention of having an object of realizing a smaller surface acoustic wave device, it is desirable to set at 500 µm or less.

Further, in the present invention, a plurality of support bases consisting of identical material or different materials can be stacked in a direction of thickness to constitute a support base. In the support base having such a laminate structure, by stacking an upper support base of prescribed shape on a lower support base, the concave portion or the protruded portion can be formed with ease.

In a surface acoustic wave device involving the third invention, since a thickness t of a surface acoustic wave absorbing member is smaller than a magnitude of a gap t0 between the electrode surface of the piezoelectric substrate and the conductor layer surface of the support base (t < t0), without the surface acoustic wave absorbing member contacting with the surface of the conductor layer, the surface acoustic wave element can be mounted and assembled. Accordingly, a surface acoustic wave element having a surface acoustic wave absorbing member can be mounted and assembled on the support base by use of FDB method, resulting in a surface acoustic wave device of smaller size and of excellent frequency characteristics.
Fig. 1 is a cross-section showing a first embodiment of the present invention.
Fig. 2A and Fig. 2B are a plan view and a cross-section respectively, showing a surface acoustic wave element being used in a first embodiment of the present invention.
Fig. 3A and Fig. 3B are respectively a plan view and a cross-section showing a support base being used in a first embodiment of the present invention.
Fig. 4A and Fig. 4B are a plan view and a cross-section showing, with a conductor layer removed, a support base being used in a second embodiment of the present invention.
Fig. 5A, Fig. 5B and Fig. 5C are cross-sections showing support bases being used in modification examples 1 to 3 of a second embodiment of the present invention, respectively.
Fig. 6A and Fig. 6B are a plan view and a cross-section, respectively, showing a support base being used in a third embodiment of the present invention.
Fig. 7A, Fig. 7B and Fig. 7C are, respectively, a plan view and cross-sections of two different cross-sections showing a support base being used in a fourth embodiment of the present invention.
Fig. 8 is a cross-section showing a fourth embodiment of the present invention.
Fig. 9 is a cross-section showing a structure of an existing surface acoustic wave device.

In the following, embodiments of the present invention will be described with reference to the drawings.

### (Embodiment 1)

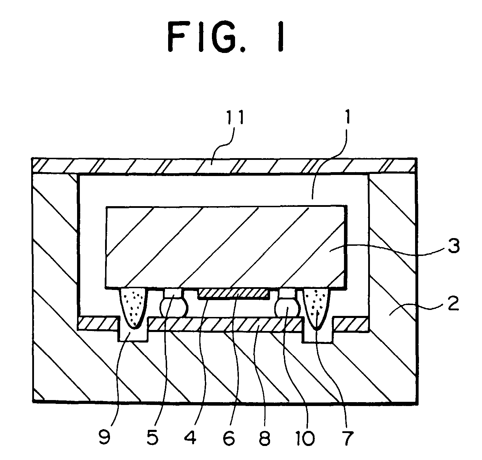

Fig. 1 is a cross-section showing a first embodiment of the present invention. As shown in this figure, a surface acoustic wave element 1 is disposed on a die-attach surface (a surface facing and connected to the surface acoustic wave element 1) of a support base 2 of rectangular box shape constituting a main portion of a package to mount.

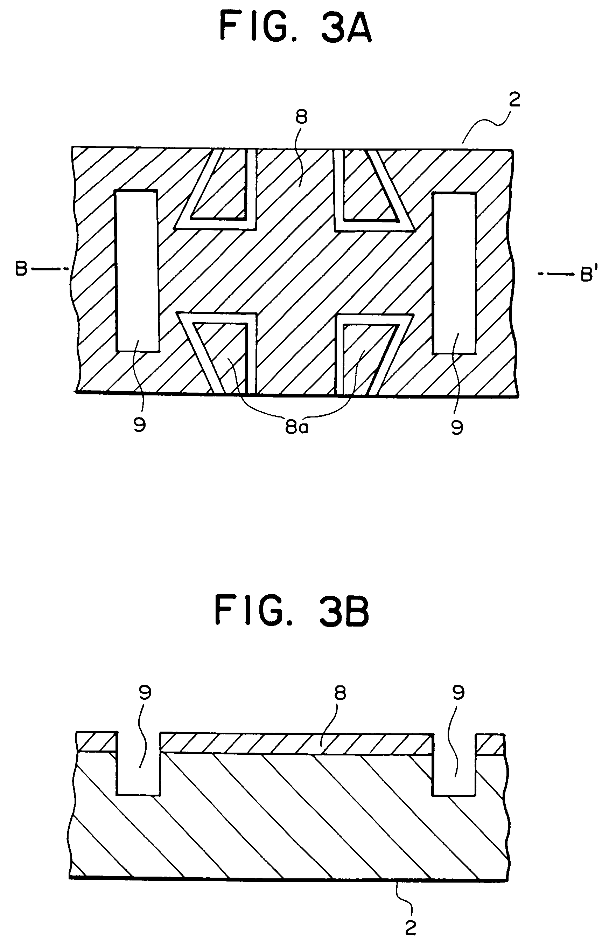

A surface acoustic wave element 1 comprises a comb-electrode 4, a bonding pad 5, a shield electrode 6 and a surface acoustic wave absorbing member 7 for attenuating surface acoustic waves. On the support base 2, a conductor layer 8 and a concave portion 9 are formed. The bonding pad 5, through a bump 10 such as Au or the like, is connected to the conductor layer 8, particularly to a signal terminal 8a that will be shown later in Fig. 3 on the support base 2. The surface acoustic wave element 1 is mounted in face down manner (with a surface thereon the comb-electrode 4 is formed directing downwards) with respect to the support base 2. That is, the surface thereon the comb-electrode 4 is formed of the surface acoustic wave element 1 faces a die-attach surface of the support base 2.

The surface acoustic wave absorbing member 7 of the surface acoustic wave element 1 is fit in, without making a contact, the inside of the concave portion 9 formed on the die-attach surface of the support base 2.

Further, on the upper edge portion of the support base 2 thereon the surface acoustic wave element 1 is mounted by use of flip chip method, a cap 11 having a rectangular plane shape identical with that of the support base 2 is covered, and these are connected to each other due to adhesive or the like. As a result of this, a container formed of the support base 2 and the cap 11 is sealed to be airtight.

On an exterior surface of the support base 2, an external-connection pad is disposed and the external-connection pad and the signal terminal 8a of the support base 2 are made conductive through a via-hole or the like. This connection structure is not shown in the figure.

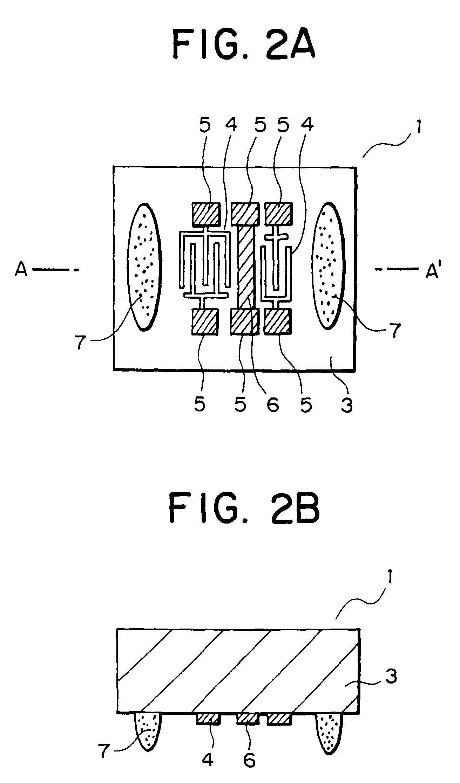

Figs. 2A and 2B are diagrams showing the details of a surface acoustic wave element 1 in a first embodiment. These figures are a plan view of the surface acoustic wave element 1 seeing from an electrode surface and a cross-section thereof cut along A-A' of Fig. 2A, respectively.

As shown in these figures, a surface acoustic wave element 1 is constituted of a piezoelectric substrate 3, a pair of comb-electrodes 4 formed on the piezoelectric substrate 3 by patterning conductor such as Al or the like, bonding pads 5 and a shield electrode 6. On the piezoelectric substrate 3, in an area between the comb-electrode 4 and an edge surface of the support base, the surface acoustic wave absorbing member 7 is disposed. Here, for instance, the surface acoustic wave absorbing member 7 consists of a layer of resin material such as silicone type or epoxy type.

One of the pair of comb-electrodes 4 functions as an transmitter of surface acoustic waves, the other one as a receiver, and in combination they function as, for instance, a filter. The shield electrode 6 alleviates an electromagnetic coupling between the pair of comb-electrodes 4 to improve performance of the surface acoustic wave element 1. The surface acoustic wave absorbing member 7 prevents surface acoustic waves from reflecting at the edge of the piezoelectric substrate 3. That is, the surface acoustic wave absorbing member 7 attenuates surface acoustic waves travelling from the comb-electrode 4 toward the edge portion of the piezoelectric substrate 3 and keeps the surface acoustic waves from returning to the comb-electrode 4 after reflection at the edge of the piezoelectric substrate 3.

Figs. 3A and 3B are diagrams showing the details of the support base 2 in the first embodiment. These figures are a plan view showing a plane seeing the support base 2 from a connection surface (die-attach surface) facing the surface acoustic wave element 1 and a cross-section cut the support base 2 along B-B' in Fig. 3A, respectively. As shown in these figures, on the die-attach surface of the support base 2, the conductor layer (conductor pattern) 8 including a pattern of the signal terminal 8a is formed, and on a circumference area outside of the signal terminal 8a the concave portion 9 having prescribed size and depth is disposed. To the signal terminal 8a, a bump 10 is connected.

In the surface acoustic wave device thus constituted of the first embodiment 1, on the die-attach surface of the support base 2, on the circumference area thereof facing the surface acoustic wave absorbing member 7 on the surface acoustic wave element 1, the concave portion 9 is disposed. As a result of this, in mounting the surface acoustic wave element 1 on the die-attach surface of the support base 2 with a bump 10, the surface acoustic wave absorbing member 7 does not contact with the die-attach surface of the support base 2. Accordingly, the surface acoustic wave absorbing member 7 does not cause a disturbance in mounting the surface acoustic wave element 1, resulting in reduction of electrical connection failure of connecting places of the surface acoustic wave element 1 and the support base 2.

Further, in the present embodiment, the surface acoustic wave element 1 having the surface acoustic wave absorbing member 7, without increasing the size of bump 10, can be mounted on the support base 2 by use of FDB method (face down bonding method). Accordingly, a surface acoustic wave device of smaller size and of excellent frequency characteristics can be obtained with ease.

In the first embodiment, inside of the concave portion 9 of the support base 2 embedded therein the surface acoustic wave absorbing member 7 of the surface acoustic wave element 1, resin can be filled further. Thus, the resin-filled layer and the surface acoustic wave absorbing member 7 are connected to strengthen further the mechanical binding between the surface acoustic wave element 1 and the support base 2.

That is, in mounting a surface acoustic wave element 1, when the resin is liquid, the resin can be almost neglected to cause a disturbance in mounting the surface acoustic wave element 1. After the surface acoustic wave element 1 is mounted on the support base 2, the resin can be solidified by heating or by leaving as it is.

Now, the resin is desirable to be insulating. If the resin is conductive, electrical noise and stray capacity might be caused.

### (Embodiment 2)

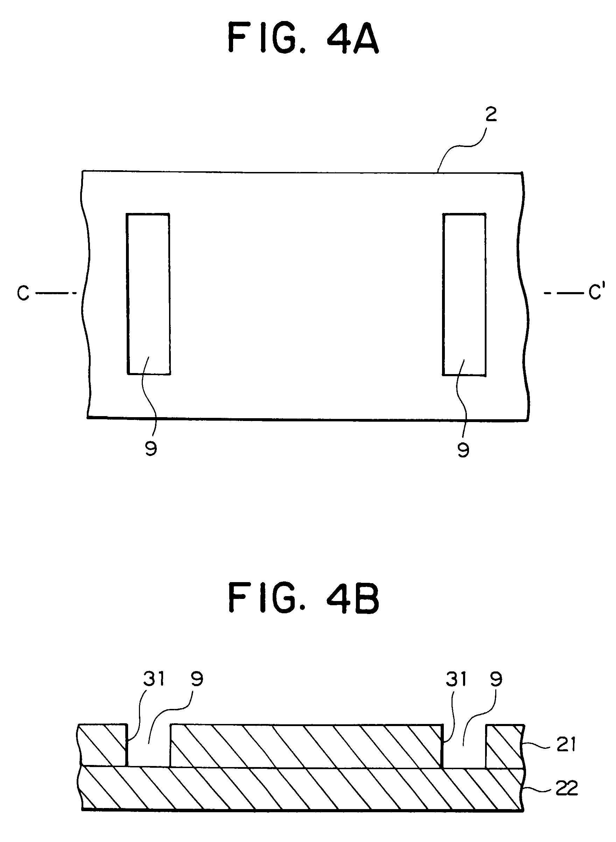

Next, a second embodiment of the present invention will be described. Figs. 4A and 4B are diagrams showing a state where on a support base 2 being used in the second embodiment of the present invention, a conductor layer 8 is not formed. These figures are a plan view showing a plane seen from a die-attach surface and a cross-section cut along C-C', respectively. In the present embodiment, a state where the conductor layer 8 is formed on the support base 2 is identical with that of Fig. 3A.

The bottom portion of the support base 2 is constituted in a laminate structure in which an upper base material 21 and a lower base material 22 are stacked. On the lower base material 22, the upper base material 21 therein a rectangular through-hole 31 is formed is stacked. As a result of this, a concave portion 9 of the support base 2 is constituted of the through-hole 31 and an upper surface of the lower base material 22. That is, the upper base material 21 therein the through-hole 31 is formed and the lower base material 22 absent of the through-hole are stacked to form the concave portion 9 of the support base 2 with ease.

In the present embodiment, a depth of the concave portion 9 is determined by the thickness of the upper base material 21. Accordingly, the present embodiment, in spite of material that is difficult in processing such as ceramics, can form the concave portion 9 with high accuracy.

The through-hole 31 can be formed by, for instance, cutting the upper base material 21. Further, when the upper base material 21 is ceramic material, the ceramic material can be die-cut before curing through firing, resulting in formation of the concave portion 9.

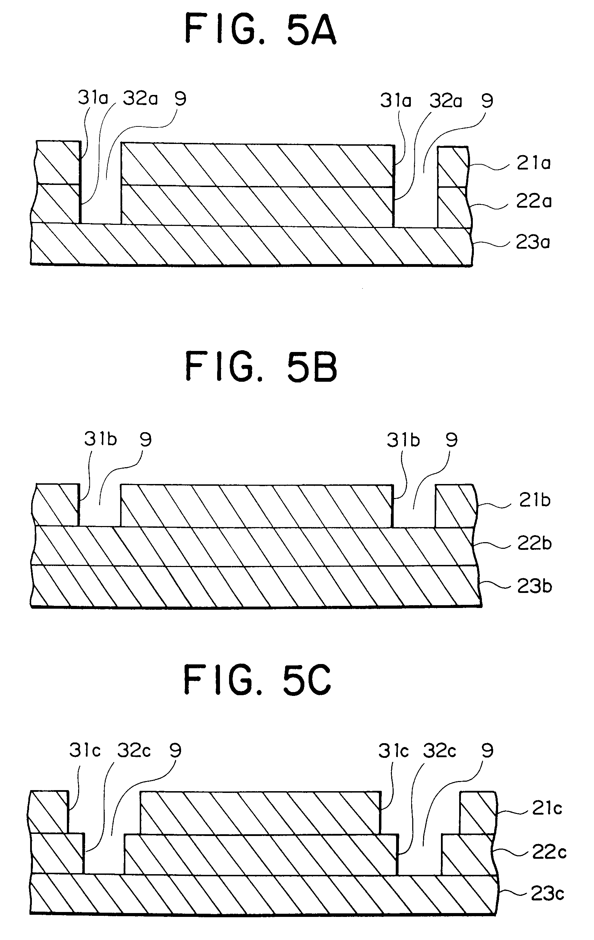

Next, modification examples of the second embodiment of the present invention will be shown. Figs. 5A, 5B and 5C correspond to Fig. 4B and show cross-sections of the support base 2.

Fig. 5A shows a first modification example of the second embodiment. Here, the upper base materials 21a and 21b are stacked on the lower base material 23a to form the bottom portion of the support base 2 of a three-layer structure. In the upper base materials 21a and 21b, through-holes 31a and 32a of the same shape are formed, respectively. As a result of this, the depth of the concave portion 9 becomes a value added the depths of the through-holes 31a and 31b.

Further, Fig. 5B shows a second modification example of the second embodiment. Here, upper base material 21b is stacked on lower base materials 22b and 23b to form a bottom portion of the support base 2 of three-layer structure. Only in the upper base material 21b, a through-hole 31b is formed. As a result of this, the depth of the concave portion 9 is determined by the thickness of the upper base material 21b and the thickness from the bottom surface of the concave portion 9 to the bottom surface of the support base 2 is determined by a summation of the thicknesses of the lower base materials 22b and 23b.

Still further, Fig. 5C shows a third modification example of the second embodiment. Here, upper base materials 21c and 22c are stacked on lower base material 23c to form a bottom portion of the support base 2 of three-layer structure. A through-hole 31c formed in the upper base material 21c is larger in dimension than a through-hole 32c formed in the upper base material 22c. As a result of this, the shape of the concave portion 9 is varied in two steps at the upper portion and lower portion. The depth of the concave portion 9 can be obtained by adding the depths of the through-holes 31c and 32c.

As shown in the above, in the second embodiment, upper base material therein a through-hole is formed is stacked on lower base material to form a concave portion 9 with ease. Number of sheets and shapes of the through-holes to be stacked, and ways of combination can be varied variously to form through-hole of various shapes, dimensions or the like.

In the above Figs. 4 and 5, for allowing easy understanding, base materials of the same thickness are stacked. On the other hand, by employing base materials of different thicknesses, the dimension of the concave portion 9 can be more precisely controlled.

### (Embodiment 3)

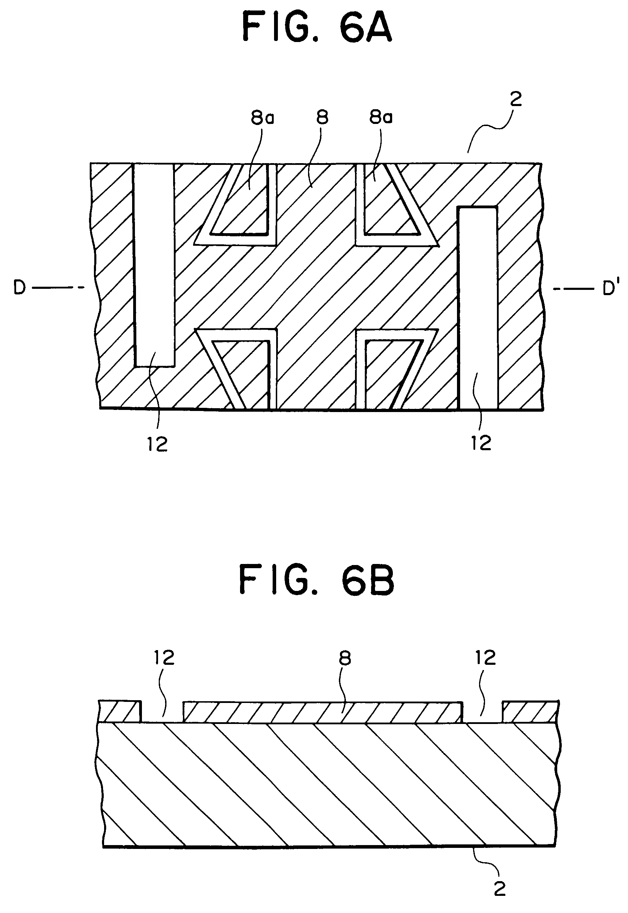

Next, a third embodiment of the present invention will be shown. Figs. 6A and 6B show a support base 2 being used in the second embodiment of the present invention. Here, Fig. 6A shows a plan view seeing the support base 2 from a die-attach surface and Fig. 6B shows a cross-section cut the support base 2 along D-D' in Fig. 6A.

As shown in these figures, on an area on a die-attach surface of the support base 2 and facing a surface acoustic wave absorbing member 7, an area 12 where a conductor layer 8 is not formed is disposed. Here, the conductor layer 8 is formed for a signal terminal 8a or as a mark in mounting by use of plating or the like.

This portion 12 where the conductor layer is not formed, in the die-attach surface of the support base 2, has a step corresponding to a thickness of the conductor layer 8 and functions as a concave portion. As a result of this, depending on a thickness of the surface acoustic wave absorbing member 7 of a surface acoustic wave element 1, the surface acoustic wave absorbing member 7 can be prevented from making contact with the support base 2. Thus, an object of the present invention can be sufficiently accomplished.

### (Embodiment 4)

Next, a fourth embodiment of the present invention is explained.

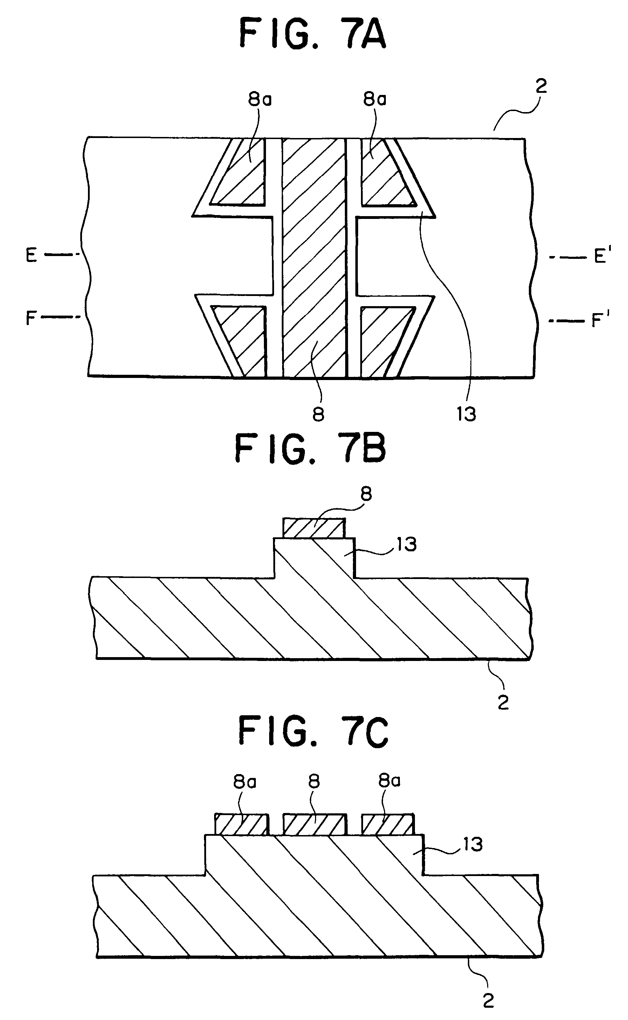

Fig. 7A through Fig. 7C shows a support base 2 being used in the fourth embodiment of the present invention. Here, Figs. 7A, 7B and 7C are a plan view seeing the support base 2 from a die-attach surface, a cross-section cut the support base 2 along E-E' in Fig. 7A and a cross-section cut the support base 2 along F-F' in Fig. 7A.

As shown in these figures, in this embodiment, only a bump connection area of the die-attach surface of the support base 2 is formed protruding in a direction of the thickness of the support base 2. On this protrusion 13, a conductor layer (conductor pattern) 8 including a signal terminal 8a is formed.

Here, the protrusion 13 can be formed as a laminate structure in which a plurality of base materials is stacked in a direction of thickness to form a support base 2. That is, on a lower base material, a small piece of prescribed shape is stacked as an upper base material to form the protrusion 13.

On the die-attach surface of the support base 2 having such a protrusion 13, a surface acoustic wave element 1 having a surface acoustic wave absorbing member is disposed in face down way to mount. A bonding pad of the surface acoustic wave element 1 and a signal terminal 8a formed on the protrusion 13 of the support base 2 are connected through a bump such as Au or the like. Since such a mounting portion is constituted as identical as embodiment 1, the figure is omitted here.

In a surface acoustic wave device of the fourth embodiment thus constituted, only an area connecting with the bump 10 on the die-attach surface of the support base 2 is formed protruding in a direction of the thickness of the support base 2. On this protrusion 13, a signal terminal 8a is formed. An area on the die-attach surface of the support base 2 other than the connection area and a piezoelectric substrate of the surface acoustic wave element 1 are separated with a gap of sufficient magnitude. As a result of this, without the surface acoustic wave absorbing member making contact with the die-attach surface of the support base 2, the surface acoustic wave element can be mounted.

In the present embodiment, in mounting the surface acoustic wave element 1 on the support base 2 with a bump 10, the surface acoustic wave absorbing member 7 does not contact with the die-attach surface of the support base 2. Accordingly, the surface acoustic wave absorbing member 7 does not become a disturbance in mounting the surface acoustic wave element 1, and connection failure at the places connecting the surface acoustic wave element and the support base occurs less frequently.

Further, in the present embodiment, the surface acoustic wave element having the surface acoustic wave absorbing member 7, without increasing the size of the bump 10, can be mounted on the support base 2 by use of the FDB method. Accordingly, a surface acoustic wave device of smaller size and of excellent frequency characteristics can be obtained.

### (Embodiment 5)

A fifth embodiment of the present invention will be explained. Fig. 8 is a cross-section showing a fifth embodiment of the present invention.

As shown in this figure, a thickness t of a surface acoustic wave absorbing member 7 of a surface acoustic wave element 1 is formed smaller (thinner) than a height of a connection bump that is described later. A surface acoustic wave element 1 having such a surface acoustic wave absorbing member 7 is disposed in face down way to mount on a conductor surface of the support base 2. In addition, a bonding pad 5 of the surface acoustic wave element 1 and a signal terminal 8a of the support base 2 are connected through a bump 10 such as Au or the like.

A thickness t of the surface acoustic wave absorbing member 7 is formed smaller than a height of a bump 10, that is, smaller than a magnitude t0 (t < t0) of a gap portion between an electrode surface of the piezoelectric substrate 3 and the conductor 8 surface of the support base 2. That is, in a mounted state, the surface acoustic wave absorbing member 7 is held without making contact with a conductor layer 8 of the support base 2.

Further, at an upper hem of the support base 2 thereon a surface acoustic wave element 1 is mounted by use of the flip chip method, a cap 11 of rectangular plane shape identical with the support base 2 is disposed, and these are connected with adhesive or the like. As a result of this, a container formed of the support base 2 and the cap 11 is sealed to be airtight.

In the surface acoustic wave device of the fifth embodiment thus constituted, a thickness t of the surface acoustic wave absorbing member 7 is formed smaller than a magnitude t0 of the gap between the electrode surface of the piezoelectric substrate 3 and the die-attach surface of the support base 2. Accordingly, without the surface acoustic wave absorbing member 7 making contact with the support base 2, the surface acoustic wave absorbing member 7 and the die-attach surface of the support base 2 can be held with an appropriate gap therebetween.

In order to form a thickness t of a surface acoustic wave absorbing member 7 smaller than a magnitude t0 of a gap between the electrode surface of the piezoelectric substrate 3 and the die-attach surface of the support base 2, the following means can be thought of.

### (1) Using a bump 10 of a height higher than a thickness of the surface acoustic wave absorbing member 7.

That is, both a signal terminal 8a formed on the die-attach surface of the support base 2 and a bonding pad 5 formed on the piezoelectric substrate 3 are formed with a thickness of approximately several µm. Accordingly, the magnitude (t0) of the gap between the piezoelectric substrate 3 of the surface acoustic wave element 1 and the die-attach surface of the support base 2 is determined by the height of the bump 10 connecting them.

Due to use of the bump 10 of a diameter larger than the thickness of the surface acoustic wave absorbing member 7, without changing the material and shape of the surface acoustic wave absorbing member 7 from ordinary ones, the surface acoustic wave absorbing member 7 can be prevented from contacting with the die-attach surface.

### (2) Making thinner the thickness of the surface acoustic wave absorbing member 7.

From the size of an ordinary bump 10, the magnitude of the gap becomes, for instance, 20 to 40 µm. The use of the surface acoustic wave absorbing member 7 thinner than the magnitude of this gap can prevent the surface acoustic wave absorbing member 7 from making contact with the die-attach surface.

However, by only thinning the thickness of the surface acoustic wave absorbing member 7, in some cases, the surface acoustic wave absorbing member 7 may not sufficiently exhibit a function of attenuating surface acoustic waves.

There are the following methods which can make thinner the surface acoustic wave absorbing member and does not decrease an attenuating effect of the surface acoustic waves.
a. Increasing an occupation area of the surface acoustic wave absorbing member 7.
   Even though the surface acoustic wave absorbing member 7 is made thinner, an increase of the area thereof can compensate the thinning effect. As a result of this, when a total volume of the surface acoustic wave absorbing member 7 is not varied so much, an attenuating effect of surface acoustic waves is not deteriorated.
b. Using the surface acoustic wave absorbing member 7 consisting of material of larger density.
   Even though the volume of the surface acoustic wave absorbing member 7 is decreased due to thinning of the surface acoustic wave absorbing member 7, material of larger density can compensate the adverse effect. When the mass of the surface acoustic wave absorbing member 7 is not varied so much, an attenuating effect of surface acoustic waves is hardly deteriorated.
c. Mixing material of larger density with the surface acoustic wave absorbing member 7.
   In specific, material of larger density than resin material such as glass bead or metallic powder is appropriately added in, for instance, liquid resin material, followed by dripping part thereof on the piezoelectric substrate 3. Thereafter, the liquid surface acoustic wave absorbing member 7 needs only be cured.

Due to the aforementioned (1) and (2), the thickness t of the surface acoustic wave absorbing member 7 can be made smaller than the magnitude t0 of the gap between the electrode surface of the piezoelectric substrate 3 and the die-attach surface of the support base 2. Here, the aforementioned (1), (2), a through c can be appropriately combined.

As a result of this, since a concave or a protrusion is not required to form on the die-attach surface of the support base 2, on the support base 2 having a flat die-attach surface, a surface acoustic wave element 1 can be mounted to assemble. For instance, with a bump 10 of a larger size than ordinary one, the thickness of the surface acoustic wave absorbing member 7 is determined accordingly, in addition to this material of larger density is mixed in the surface acoustic wave absorbing member 7 and so on.

As mentioned above, a surface acoustic wave element having a surface acoustic wave absorbing member on an electrode surface can be mounted by use of the FDB method. Thereby, a surface acoustic wave device of smaller size and of excellent frequency characteristics can be obtained.

The present invention can be extended and modified in the range of the spirit of the present invention, and such extension and modification are included in the technical range of the present invention.

The surface acoustic wave element involving the present invention is not restricted to the structure of Fig. 2 and the shape of the support base is not restricted to the rectangular box.

The fundamental thought of the present invention, in mounting a surface acoustic wave element having a surface acoustic wave absorbing member on a support base by use of FDB method, is to prevent the surface acoustic wave absorbing member from contacting with a support base surface. As a result of this, in mounting, a surface acoustic wave element and a support base are prevented from causing electrical connection failure. All constitution performing such effects is included in the present invention.

For instance, instead of disposing a concave in a support base, a through-hole may be holed. This hole may be sealed with adhesive or the like as demand arises.

Further, in mounting a surface acoustic wave element, a surface acoustic wave absorbing member can be maintained in liquid, followed by solidifying. When the material of a surface acoustic wave absorbing member is dripped in liquid on a piezoelectric substrate and a surface acoustic wave element is mounted on a support base, as it is, the surface acoustic wave absorbing member does not cause disturbance in mounting.

## Claims

1. A surface acoustic wave device, comprising:
a surface acoustic wave element comprising a piezoelectric substrate, and a pair of comb-electrodes and a surface acoustic wave absorbing member both of which are formed on the piezoelectric substrate; and
a support base thereon the surface acoustic wave element is mounted in face-down way;
wherein the support base comprises a conductor layer formed on a surface facing the surface acoustic wave element and connected with the surface acoustic wave element through a bump;
wherein the support base comprises a concave portion in an area facing the surface acoustic wave absorbing member.

2. The surface acoustic wave device as set forth in claim 1:
wherein the support base comprises a laminate structure in which an upper base of prescribed shape is stacked on a lower base.

3. The surface acoustic wave device as set forth in claim 2:
wherein the upper base comprises a through-hole of a shape corresponding to the concave.

4. The surface acoustic wave device as set forth in claim 3:
wherein the upper base comprises a laminate structure in which a plurality of bases are stacked.

5. The surface acoustic wave device as set forth in claim 1:
wherein the surface acoustic wave absorbing member is embedded without contacting in the concave of the support base.

6. The surface acoustic wave device as set forth in claim 5:
wherein inside of the concave portion, a resin layer is comprised in contact with the surface acoustic wave absorbing member.

7. The surface acoustic wave device as set forth in claim 1:
wherein the surface acoustic wave device comprises a cap covering the surface acoustic wave element and adhered to the support base to seal air tight the surface acoustic wave element.

8. The surface acoustic wave device as set forth in claim 1:
wherein a depth of the concave is in the range of 2 µm or more and 500 µm or less.

9. A surface acoustic wave device, comprising:
a surface acoustic wave element comprising a piezoelectric substrate, and a comb-electrode and a surface acoustic wave absorbing member both of which are formed on the piezoelectric substrate; and
a support base thereon the surface acoustic wave element is mounted in face-down way;
wherein the support base comprises a conductor layer formed on a surface facing the surface acoustic wave element and connected with the surface acoustic wave element through a bump;
wherein an area connecting with the bump on the support base is formed on a portion protruded in a thickness direction with respect to an area facing the surface acoustic wave absorbing member.

10. The surface acoustic wave device as set forth in claim 9:
wherein the support base comprises a laminate structure in which an upper base consisting of a small piece of a shape corresponding to the protruded portion is stacked on a lower base.

11. The surface acoustic wave device as set forth in claim 9:
wherein the surface acoustic wave device comprises a cap covering the surface acoustic wave element and adhered to the support base to seal air tight the surface acoustic wave element.

12. The surface acoustic wave device as set forth in claim 10:
wherein a step from the facing area of the protruded portion is in the range of 2 µm or more and 500 µm or less.

13. A surface acoustic wave device, comprising:
a surface acoustic wave element comprising a piezoelectric substrate, and a comb-electrode and a surface acoustic wave absorbing member both of which are formed on the piezoelectric substrate; and
a support base thereon the surface acoustic wave element is mounted in face-down way;
wherein the support base comprises a conductor layer formed on a surface facing the surface acoustic wave element and connected with the surface acoustic wave element through a bump;
wherein a thickness of the surface acoustic wave absorbing member is smaller than a gap between one surface of the surface acoustic wave element thereon the comb-electrode is formed and the conductor layer.

14. The surface acoustic wave device as set forth in claim 13:
wherein at an upper edge portion of the support base, a cap is disposed so as to cover an upper portion of the surface acoustic wave element to seal the cap and the support base airtight.

15. A package being used for a surface acoustic wave element comprising a surface acoustic wave absorbing member, comprising:
a support base having one surface thereon the surface acoustic wave element is mounted;
a conductor layer formed on the surface; and
a concave portion formed in an area facing the surface acoustic wave absorbing member on the surface.

16. The package as set forth in claim 15:
wherein the support base comprises a laminate structure in which an upper base of prescribed shape is stacked on a lower base.

17. The package as set forth in claim 15:
wherein a depth of the concave is in the range of 2 µm or more and 500 µm or less.

18. A package for a surface acoustic wave element, comprising:
a support base comprising one surface thereon the surface acoustic wave element is mounted;
a protrusion disposed in an area where the surface acoustic wave element on the surface is connected with and protruded in a direction of thickness of the support base; and
a conductor layer formed on the protrusion.

19. The package as set forth in claim 18:
wherein the support base comprises a laminate structure in which an upper base consisting of a small piece of a shape corresponding to the protrusion is stacked on a lower base.

20. The package as set forth in claim 18:
wherein a step from the facing area of the protrusion is in the range of 2 µm or more and 500 µm or less.
